# EUROPEAN PATENT SPECIFICATION

(11) **EP 0 442 491 B1**
(45) Date of publication and mention of the grant of the patent: **15.11.1995**
(21) Application number: 91102091.5
(22) Date of filing: 14.02.1991
(51) Int. Cl.: H01L 23/522, H01L 23/528

(54) **Semiconductor device having a wiring pattern in which a plurality of lines are arranged in close proximity to one another**
Halbleiteranordnung mit einem Leitermuster, in dem mehrere Linien dicht nebeneinander angeordnet sind
Dispositif semi-conducteur comprenant une configuration de conducteurs dans laquelle une pluralité de lignes sont arrangeés d'une façon très serrée

(30) Priority: 14.02.1990 JP 31488/90
(43) Date of publication of application: 21.08.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Suzuki, Hidenori, c/o Intellectual Property Div., Minato-ku, Tokyo 105 (JP); Yamano, Satoshi, c/o Intellectual Property Div., Minato-ku, Tokyo 105 (JP)
(74) Representative: Lehn, Werner, Dipl.-Ing.

(56) References cited:
- PATENT ABSTRACTS OF JAPAN vol. 12, no. 287 (E-643) August 5, 1988 & JP-A-63 64 339
- PATENT ABSTRACTS OF JAPAN vol. 12, no. 355 (E-661) September 22, 1988 & JP-A-63 111 644
- IBM TECHNICAL DISCLOSURE BULLETIN, vol. 31, no. 10, March 1989, NEW YORK, US: pages 213-215; 'Method of improving the yield of VLSI logic chips by using a variable wiring channel pitch'

## Description

This invention relates to a semiconductor device having a plurality of lines arranged in close proximity to one another, and more particularly to a semiconductor device having a fine line pattern.

In general, it is necessary for the line pattern of a semiconductor device to be designed such that lines are arranged at minimum intervals, in accordance with design rules, since the size of a chip is limited.

In a conventional semiconductor device, a plurality of patterned lines are arranged at minimum intervals, before and after they are bent at their bending portions. In other words, the interval between adjacent lines is the same in any portion of the line pattern.

A CVD oxide film is formed on the entire line pattern, except for the bonding pads, to protect the surface of the chip. More specifically, after the line pattern is formed, a CVD oxide film is deposited on the chip and openings are then formed in desired portions of the CVD film by means of the following steps: a CVD film depositing step, a cleaning step, a drying step, a resist applying step, a resist pre-baking step, a pattern printing step, a developing step, and a CVD film etching step.

If the interval between adjacent lines is too small, pores tend to form between the adjacent lines when the CVD film is formed, due to overhanging of the CVD film.

If pores are formed in the CVD oxide film as described above, a liquid used in the succeeding cleaning step tends to fill the pores in the bending portion of the line pattern due to the capillary phenomenon. The liquid which fills the pores does not dry sufficiently in the drying step and remains in the bending portion. Then, as the liquid is vaporized in the resist pre-baking step, the resist film which has been applied to the CVD film explodes, thereby forming a hole. Consequently, a portion which should have been covered by the resist film is exposed, and undesirable etching is performed on that portion, resulting in a defective device.

Even if the pores in the CVD film are not filled with liquid, they may fill with gas, in which case, the gas will expand in the resist pre-baking step, again forming a hole.

IBM Technical Disclosure Bulletin, vol. 31, no. 10, March 1989, pages 213 to 215 discloses a semiconductor device which shows first and second wiring lines arranged on an insulating layer, the respective end portions of the first and second lines being connected to each other and the second lines having a width which is larger than that of the first lines.

Patent Abstracts of Japan, vol. 12, no. 287 (E-643), 5 August 1988 and JP-A-63 064 399 disclose that patterned lines are covered by a CVD oxide film.

It is accordingly an object of the invention to provide a semiconductor device in which a CVD oxide film is deposited on a line pattern having a bending portion and a plurality of patterned lines arranged at predetermined intervals, wherein undesirable etching of the CVD oxide film is prevented.

This object is achieved according to claim 1 of the present application.

Preferred embodiments are listed in the dependent claims.

This invention can be more fully understood from the following detailed description when taken in conjunction with the accompanying drawings, in which:
Fig. 1A is a plan view showing a line pattern of a conventional semiconductor device;
Fig. 1B is a cross sectional view of the device shown in Fig. 1A;
Fig. 2A is a plan view showing a line pattern of a semiconductor device according to a first embodiment of the present invention;
Fig. 2B is a cross sectional view of the device shown in Fig. 2A taken along the line II-II;
Fig. 3 is a plan view showing a line pattern of a semiconductor device according to a second embodiment of the present invention;
Fig. 4 is a cross sectional view for explaining the first and second embodiments;
Fig. 5 is a plan view showing a line pattern of a semiconductor device according to a third embodiment of the present invention;

In general, it is necessary for the line pattern of a semiconductor device to be designed such that lines are arranged at minimum intervals, in accordance with design rules, since the size of a chip is limited.

In a conventional semiconductor device, a plurality of patterned lines are arranged at minimum intervals, before and after they are bent at their bending portions.

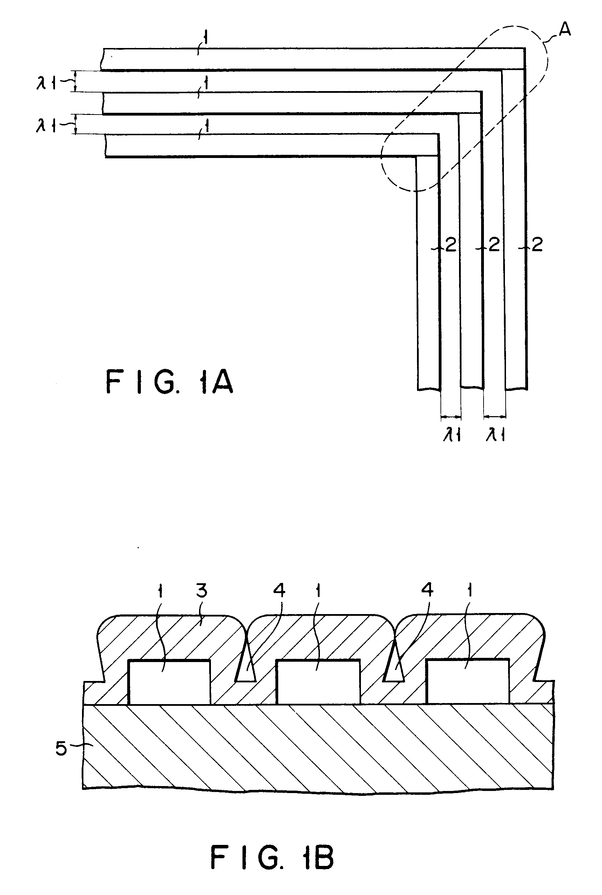

For example, as shown in Fig. 1A, three lines 1, 1, 1, which are made of aluminum or the like and extend in a horizontal direction, are arranged at minimum intervals λ1 according to design rules. Three other lines 2, 2, 2 made of aluminum or the like extend perpendicular to the lines 1, 1, 1, and are connected to the end portions of the lines 1, 1, 1. The lines 2, 2, 2 are also arranged at minimum intervals. The lines 1, 1, 1 and 2, 2, 2 have minimum widths according to the design rules.

In a conventional method of manufacturing a semiconductor device, a CVD oxide film is formed on the entire line pattern to protect the surface of the chip. More specifically, after the line pattern is formed, a CVD oxide film is deposited on the chip and openings are then formed in desired portions of the CVD film by means of the following steps: a CVD film depositing step, a cleaning step, a drying step, a resist applying step, a resist pre-baking step, a pattern printing step, a developing step, and a CVD film etching step.

If the interval between adjacent lines is too small, pores tend to form between the adjacent lines when the CVD film is formed, due to overhanging of the CVD film. This is prominent particularly in the bending portion A of the line pattern as shown in Fig. 1A, i.e. a portion in which the lines 1, 1, 1 are connected to the lines 2, 2, 2.

Fig. 1B shows a state in which pores 4 are formed in the CVD oxide film 3. In general, the lines 1, 1, 1 and 2, 2, 2 are formed on an insulation film 5.

If pores 4 are formed in the CVD oxide film 3 as described above, a liquid used in the succeeding cleaning step tends to fill the pores in the bending portion of the line pattern due to the capillary phenomenon. The liquid which fills the pores does not dry sufficiently in the drying step and remains especially in the bending portion. Then, as the liquid is vaporized in the resist pre-baking step, the resist film which has been applied to the CVD film explodes, thereby forming a hole. Consequently, a portion which should have been covered by the resist film is exposed, and undesirable etching is performed on that portion, resulting in a defective device.

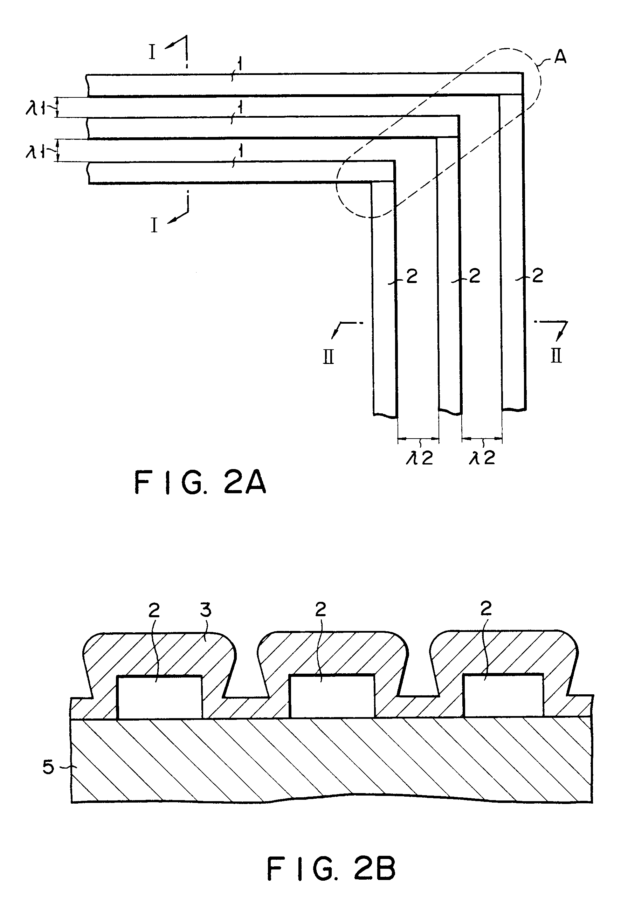

A first embodiment of the present invention will now be described with reference to Figs. 2A and 2B.

As shown in Fig. 2A, three first patterned lines 1, 1, 1, made of aluminum or the like and extending in a horizontal direction in the drawing, are arranged at minimum intervals λ1 according to design rules. Three second patterned lines 2, 2, 2, made of aluminum or the like, extend perpendicular to the lines 1, 1, 1, and their end portions are respectively connected to the end portions of the lines 1, 1, 1. The lines 2, 2, 2 are arranged at intervals λ2 which are wider than the minimum intervals λ1. All of the lines 1, 1, 1 and 2, 2, 2 have minimum widths within the limits of their design rules.

Fig. 2B shows a cross section of the line pattern taken along the line II-II of Fig. 2A. The cross section taken along the line I-I is the same as that shown in Fig. 1B. A CVD oxide film 3 is deposited on the lines 1, 1, 1 and 2, 2, 2, which are formed on an insulation film 5.

In this embodiment, since the lines 1, 1, 1 are arranged at minimum intervals λ1 on the left hand of a bending portion A in Fig. 2A, pores may be formed in that portion of the CVD film 3. However, since the interval λ2 is wider than the minimum interval λ1, even if a liquid used in the cleaning step fills the pores due to the capillary phenomenon, as in a conventional device, the liquid is discharged from the pores through the wider interval portion of the CVD film 3. Hence, explosion of the resist film due to vaporization of the liquid in the pre-baking step is prevented, and no holes are formed in the resist film.

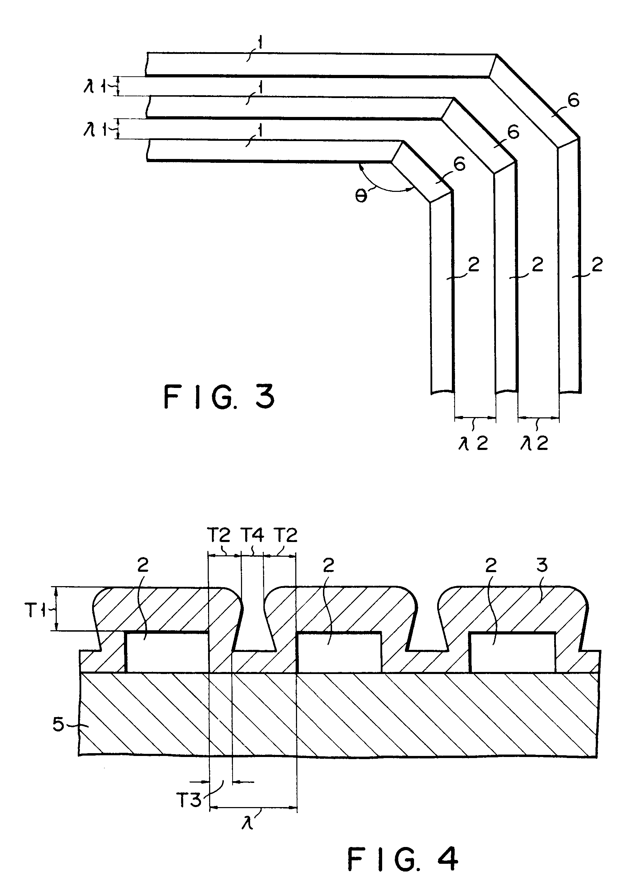

Fig. 3 shows a semiconductor device according to a second embodiment of the present invention. In this embodiment, intermediate lines 6, 6, 6 connect two sets of patterned lines 1, 1, 1 and 2, 2, 2, which are arranged at right angles to each other, in contrast to the first embodiment in which the first patterned lines 1, 1, 1 are directly connected to the second patterned lines 2, 2, 2. The intermediate lines 6, 6, 6 make an angle ϑ (ϑ = 135°C) with the lines 1, 1, 1 and 2, 2, 2.

In an integrated circuit, in general, two lines are allowed to form an angle of 90°C or 135°C. The second embodiment corresponds to the case in which two lines form an angle of 135°C. The present invention can be applied to a device in which lines bend at desired angles.

Also in the second embodiment, since the interval λ2 between the second patterned lines 2, 2 is wider than the interval λ1 between the first patterned lines 1, 1, explosion of the resist film due to vaporization of the liquid in the pre-baking step is prevented, and therefore no holes are formed in the resist film.

The relationship between the intervals λ1 and λ2 in the first and second embodiments will now be described.

Fig. 4 is a sectional view of the line pattern at a portion where the lines are arranged at intervals λ (corresponding to λ2) which is wider than the minimum interval λ1. The CVD film 3, formed on the lines 2 made of aluminum, has a thickness of T1. The thickness T2 of the overhanging portion on the shoulder of the line 2 is about 0.9·T1. The distance T3 between the edge of the bottom surface of the stepped portion of the CVD film 3 and the edge of the line 2 is about 0.8·T1. Pores are formed in the CVD film 3 due to the fact that the thickness T3 is smaller than the thickness T2. If the lines 2, 2, 2 are parallel to one another, an overhanging portion of the CVD film 3 formed on a line 2 faces close to that formed on an adjacent line 2. Hence, a distance T4 obtained by subtracting 2·T2 (the thicknesses of the overhanging portions formed on both shoulders of a line 2) from λ (the distance between two adjacent lines) reduces in reverse proportion to T1 (the thickness of the CVD film 3). If T4 is 0, a pore is formed in the CVD film 3 between the two adjacent lines, when λ is 1.8·T1 or less.

The above matter will be described using specific values. Let us assume that the line pattern is designed such that the minimum interval λ1 of the aluminum lines is 1 µm, and that the thickness of the CVD film on the aluminum lines is substantially 0.9 µm. Since the critical value of the interval λ, which makes the interval T4 of the overhanging portion of the CVD film zero, is 1.8 times the thickness T1 of the CVD film, the interval λ (corresponding to λ2 in Figs. 2A and 3) is 0.9 µm × 1.8 = 1.62 µm. Hence, to prevent a pore from forming in the CVD oxide film (on the connecting portion between lines 1 and 2, and the line 2), it is necessary to arrange the lines 2, 2, 2 at intervals of more than 1.62 µm, e.g., 1.8 µm.

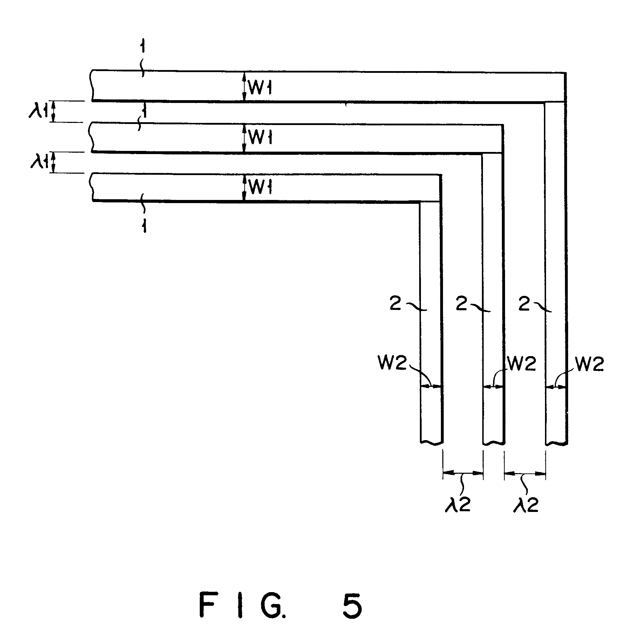

A third embodiment of the invention will now be described with reference to Fig. 5. In this embodiment, first patterned lines 1, 1, 1 have a width W1, which is wider than the minimum width according to design rules, while second patterned lines 2, 2, 2 have a width W2, which is the minimum width according to the design rules. An interval between adjacent lines 1, 1, 1 is λ1, which is the minimum interval within the limits of design rules. Ah interval between adjacent lines 2, 2, 2 is λ2, which is wider than λ1. The same effect as in the above-mentioned embodiments is obtained by the third embodiment in which the lines 1, 1, 1 have a width different from that of the lines 2, 2, 2.

This invention is not limited to the above-described embodiments but can be variously modified. For example, although the lines 2, 2, 2 are arranged at regular intervals of λ2 in the above embodiments, the intervals need not be the same. In addition, lines need not be made of aluminum, but can be made for instance of tungsten, copper, or polycrystalline silicon.

As has been described above, according to the present invention, a semiconductor device is provided in which a CVD oxide film is deposited on a line pattern having a plurality of lines arranged at predetermined intervals and a bending portion, wherein no liquid remains in the bending portion and undesirable etching of the CVD oxide film at the bending portion of the line pattern is prevented.

Reference signs in the claims are intended for better understanding and shall not limit the scope.

## Claims

1. A semiconductor device comprising:
a plurality of bent wiring lines running parallel to each other, each bent line consisting of a first patterned line (1) extending along a first direction on an insulation layer (5), a second patterned line (2) extending at a desired angle to the first direction on the insulation layer (5), and a bending portion respective first and second patterned lines of each bent line (1, 2) being connected at adjacent end portions thus forming the bending portion, said first patterned lines (1) being arranged at first intervals (λ1) and each of said first patterned lines (1) having a first width (W1), said second patterned lines (2) being arranged at second intervals (λ2) and each of said second patterned lines (2) having a second width (W2); and
a CVD oxide film (3) deposited on the entire surface of said insulation layer (5) including said first and second patterned lines (1, 2);
wherein said CVD oxide film (3) formed on said first and second patterned lines (2) has a thickness of T1 and said second intervals (λ2) are wider than said first intervals and are wider than T1 multiplied by 1.8.

2. A semiconductor device according to claim 1, characterized in that said first width (W1) is equal to said second width (W2).

3. A semiconductor device according to claim 1, characterized in that said second width (W2) is smaller than said first width (W1).

## Patentansprüche

1. Halbleitervorrichtung, umfassend:
eine Vielzahl von gekrümmten Verdrahtungsleitungen, die parallel zueinander verlaufen, wobei jede gekrümmte Leitung aus einer ersten gekrümmten Leitung (1), die sich entlang einer ersten Richtung auf einer Isolationsschicht (5) erstreckt, einer zweiten gekrümmten Leitung (2), die sich unter einem beliebigen Winkel zur ersten Richtung auf der Isolationsschicht (5) erstreckt und einen Krümmungsabschnitt besteht, wobei jeweilige erste und zweite strukturierte Leitungen jeder gekrümmten Leitung (1, 2) verbunden sind an benachbarten Endabschnitten, um somit den Krümmungsabschnitt zu bilden, wobei die ersten strukturierten Leitungen (1) unter ersten Intervallen (λ1) angeordnet sind, und jede der ersten strukturierten Leitungen (1) eine erste Breite (W1) hat, wobei die zweiten strukturierten Leitungen (2) angeordnet sind unter zweiten Intervallen (λ2) und jede der zweiten strukturierten Leitungen (2) eine zweite Breite (W2) hat; und
und einen CVD-Oxydfilm (3), der abgeschieden ist auf der gesamten Oberfläche der Isolationsschicht (5) einschließlich der ersten und zweiten strukturierten Leitungen (1, 2);
wobei der CVD-Oxydfilm (3), der auf den ersten und zweiten strukturierten Leitungen (1, 2) gebildet ist, eine Dicke von T1 hat, und die zweiten Intervalle (λ2) breiter sind als die ersten Intervalle und breiter sind um T1 multipliziert mit 1,8.

2. Halbleitervorrichtung nach Anspruch 1, dadurch gekennzeichnet, daß die erste Breite (W1) gleich ist der zweiten Breite (W2).

3. Halbleitervorrichtung nach Anspruch 1, dadurch gekennzeichnet, daß die zweite Breite (W2) kleiner ist als die erste Breite (W1).

## Revendications

1. Dispositif à semi-conducteur comprenant :
plusieurs conducteurs de câblage recourbés courant parallèlement les uns aux autres, chaque conducteur recourbé étant constitué d'un premier conducteur dessiné (1), s'étendant dans une première direction sur une couche d'isolation (5), d'un second conducteur dessiné (2) s'étendant suivant un angle voulu par rapport à la première direction sur la couche d'isolation (5), et d'une partie recourbée, les premier et second conducteurs dessinés respectifs de chaque conducteur recourbé (1, 2) étant raccordés à des parties d'extrémité adjacentes en formant ainsi la partie recourbée, lesdits premier conducteurs dessinés (1) étant disposés à des premiers intervalles (λ1) et chacun desdits premiers conducteurs dessinés (1) ayant une première largeur (W1), lesdits seconds conducteurs dessinés (2) étant disposés à des seconds intervalles (λ2) et chacun desdits seconds conducteurs dessinés (2) ayant une seconde largeur (W2) ; et
un film d'oxyde CVD (3) déposé sur toute la surface de ladite couche d'isolation (5) qui contient lesdits premiers et seconds conducteurs dessinés (1, 2) ;
dans lequel ledit film d'oxyde CVD (3) formé sur lesdits premiers et seconds conducteurs dessinés (2) a une épaisseur de T1 et lesdits seconds intervalles (λ2) sont plus larges que lesdits premiers intervalles et sont plus larges que T1 multiplié par 1,8.

2. Dispositif à semi-conducteur selon la revendication 1, caractérisé en ce que ladite première largeur (W1) est égale à ladite seconde largeur (W2).

3. Dispositif à semi-conducteur selon la revendication 1, caractérisé en ce que ladite seconde largeur (W2) est plus petite que ladite première largeur (W1).
